# EUROPEAN PATENT APPLICATION

(11) **EP 2 701 474 A2**
(43) Date of publication of application: **26.02.2014**
(21) Application number: 13171349.7
(22) Date of filing: 11.06.2013
(51) Int. Cl.: H05K 3/30, H01R 13/04, H01R 43/20

(54) **A circuit board system**

(30) Priority: 26.06.2012 FI 20125726
(71) Applicant: Tellabs Oy, 02630 Espoo (FI)
(72) Inventor: Björklöf, Alf, 03790 Vihtijärvi (FI); Holma, Antti, 02920 Espoo (FI)
(74) Representative: Berggren Oy Ab

(57) **Abstract**

A circuit board system comprising a circuit board (301) comprising a first (321) and a second functional entity (322) galvanically connected by electrically conductive elements comprising a first electrically conductive lining (317) in a hole of a circuit board, a press-fit connection pin (315) providing a friction fit with the first lining, a second lining (318) in another hole of the circuit board, a second press-fit connection pin (316) providing a friction fit with the second lining, and a connection part (302) providing a galvanic connection between the first and second press-fit connection pins, the press-fit connection pins being comprised in a press-fit installable electrical connector element (324) on an edge of the circuit board, said connection part (302) being located between the circuit board (301) the connector element (324); a method for manufacturing said circuit board system comprising testing the first and second functional entity independently before providing a galvanic connection between said functional entities.

## Description

### Field of the invention

The invention relates to a method for manufacturing a circuit board system that comprises a circuit board furnished with electrical components. Furthermore, the invention relates to a circuit board system.

### Background

A typical circuit board system comprises a circuit board furnished with electrical components. The circuit board comprises a body made of one or more layers of electrically insulating material and electrical conductors on one or both of the surfaces of the circuit board and/or between the layers of the electrically insulating material. Each of the electrical components can be, for example, an integrated circuit such as a processor or a memory, or a discrete component such as a resistor, a capacitor, an inductor, a transistor, or a diode.

A circuit board system may comprise several functional entities which co-operate with each other during the normal use of the circuit board system. A functional entity can be, for example but not necessarily, a DC-to-DC or AC-to-DC power supply converter of the circuit board system, a signal processing part of the circuit board system, an analogue signal processing part of the circuit board system, a digital signal processing part of the circuit board system, an equalizer of a digital signal processing part of the circuit board system, a detector of the digital signal processing part, or a flash memory. During the manufacture of a circuit board system that comprises several functional entities of the kind mentioned above, there is often a need to direct electrical activity, e.g. testing or data loading, to one or more of the functional entities so that the other functional entities are not involved and are disconnected from the functional entity under activation so that operations of separate functional entities are substantially free from mutual interactions. For example, one of the functional entities can be a power supply converter and another of the functional entities can be a signal processing part. In this case, there is typically a need to test the functionality of the power supply converter so that the signal processing part is not connected to the power supply converter because otherwise possible malfunctioning of the power supply converter might, in a worst case, even damage the signal processing part. For another example, one of the functional entities can be a flash memory and another of the functional entities can be a signal processing part, and data is loaded to the flash-memory with the aid of an external test fixture, e.g. a bed of nails, which supplies voltage directly to the flash memory. In this case, there is a need to prevent the voltage supplied by the external test fixture from being strayed to the signal processing part that might, in a worst case, be even damaged by stray voltages. In light of the above-presented examples, there is a need to leave e.g. in a soldering process the functional entities disconnected from each other so that operations of the functional entities are substantially free from mutual interactions and therefore electrical activity, such as testing and data loading, can be directed to a functional entity without disturbing or endangering any other functional entity.

In a known arrangement there are connection pins on the circuit board and the functional entities can be interconnected with the aid of one or more jumper elements after the appropriate functional entity-specific testing, data loading, and/or possible other activities has been carried out. An inconveniency related to this arrangement is its unsuitability for applications where the circuit board system has to be as thin as possible in the direction perpendicular to the circuit board. In another known arrangement, the functional entities are interconnected by soldering jumper wires after the functional entity-specific testing, data loading, and/or possible other activities has been carried out. An inconveniency related to this arrangement is the need for soldering after the functional entity-specific testing, data loading, and/or possible other activities.

### Summary

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

In accordance with the first aspect of the invention, there is provided a new method for manufacturing a circuit board system that can be, for example but not necessarily, a part of a telecommunication equipment. The method according to the invention comprises:
- attaching electrical components to a circuit board, the electrical components constituting together with electrical conductors of the circuit board two or more functional entities including a first functional entity and a second functional entity,
- directing electrical activity, e.g. testing and/or data loading, to at least one of the first and second functional entities, the first and second functional entities being disconnected from each other so that operations of the first and second functional entities are substantially free from mutual interactions, and
- providing, after the directing of the electrical activity, at least one galvanic connection between the first and second functional entities with the aid of electrically conductive elements, the at least one galvanic connection enabling the first and second functional entities to co-operate with each other.

The electrically conductive elements comprise an electrically conductive lining in a hole of the first circuit board and a press-fit connection pin providing a friction fit with the first electrically conductive lining.

The electrically conductive elements further comprise another electrically conductive lining in another hole of the circuit board, another press-fit connection pin providing a friction fit with the other electrically conductive lining, and a connection part providing a galvanic connection between the press-fit connection pins. The press-fit connection pins are such press-fit connection pins of a press-fit installable electrical component which press-fit connection pins can be short-circuited without causing harm to the operation of the press-fit installable electrical component. The connection part comprises holes for the press-fit connection pins so as to provide friction fits with the press-fit connection pins. The connection part can, for example, be a piece of metal or an auxiliary circuit board. The method comprises placing the connection part between the circuit board and the press-fit installable electrical component when installing the press-fit installable electrical component to the circuit board so as to provide the at least one galvanic connection. The press-fit installable electrical component is an electrical connector element on an edge of the circuit board.

In accordance with the second aspect of the invention, there is provided a new circuit board system that can be, for example but not necessarily, a part of a telecommunication equipment. The circuit board system according to the invention comprises:
- a first circuit board furnished with electrical components attached to the first circuit board, the electrical components constituting together with electrical conductors of the first circuit board two or more functional entities including a first functional entity and a second functional entity, and
- electrically conductive elements providing at least one galvanic connection between the first and second functional entities, the at least one galvanic connection enabling the first and second functional entities to co-operate with each other, and without the at least one galvanic connection the first and second functional entities being disconnected from each other so that operations of the first and second functional entities are substantially free from mutual interactions,
wherein the electrically conductive elements comprise:
- a first electrically conductive lining in a hole of the first circuit board,
- a first press-fit connection pin providing a friction fit with the first electrically conductive lining,
- a second electrically conductive lining in another hole of the first circuit board,
- a second press-fit connection pin providing a friction fit with the second electrically conductive lining, and
- a connection part providing a galvanic connection between the first and second press-fit connection pins,
wherein the first and second press-fit connection pins are press-fit connection pins of a press-fit installable electrical connector element on an edge of the first circuit board, and the connection part providing the galvanic connection between the first and second press-fit connection pins is located between the first circuit board and the press-fit installable electrical connector element.

A number of non-limiting exemplifying embodiments of the invention are described in accompanied dependent claims.

Various non-limiting exemplifying embodiments of the invention both as to constructions and to methods of operation, together with additional objects and advantages thereof, will be best understood from the following description of specific exemplifying embodiments when read in connection with the accompanying drawings.

The verbs "to comprise" and "to include" are used in this document as open limitations that neither exclude nor require the existence of unrecited features. The features recited in depending claims are mutually freely combinable unless otherwise explicitly stated.

### Brief description of the figures

The exemplifying embodiments of the invention and their advantages are explained in greater detail below in the sense of examples and with reference to the accompanying drawings, in which:
figure 1a illustrates a circuit board system according to an exemplifying embodiment of the invention,
figure 1b shows a schematic view of a section taken along the line A-A shown in figure 1a,
figure 1c shows a schematic view of a detail of the section view shown in figure 1b,
figure 2a illustrates a part of a circuit board system according to an exemplifying embodiment of the invention,
figure 2b shows a schematic view of a section taken along the line A-A shown in figure 2a.
figure 3a illustrates a circuit board system according to an exemplifying embodiment of the invention,
figure 3b shows a schematic view of a section taken along the line A-A shown in figure 3a,
figure 3c shows a schematic view of a detail of the section view shown in figure 3b,
figure 4 shows a schematic view of a section taken from a detail of a circuit board system according to an exemplifying embodiment of the invention, and
figure 5 shows a flowchart of a method according to an exemplifying embodiment of the invention for manufacturing a circuit board system.

### Description of the exemplifying embodiments

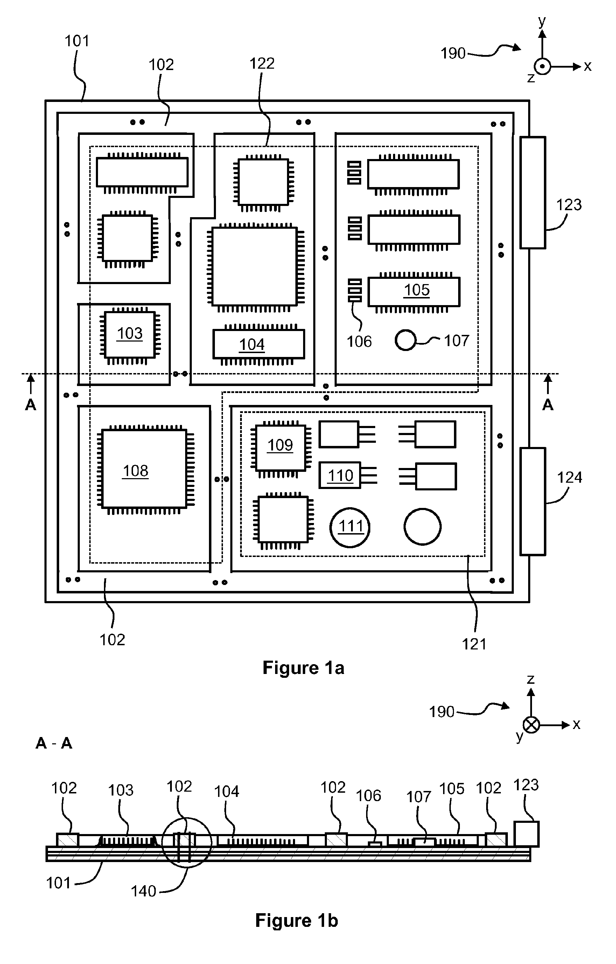

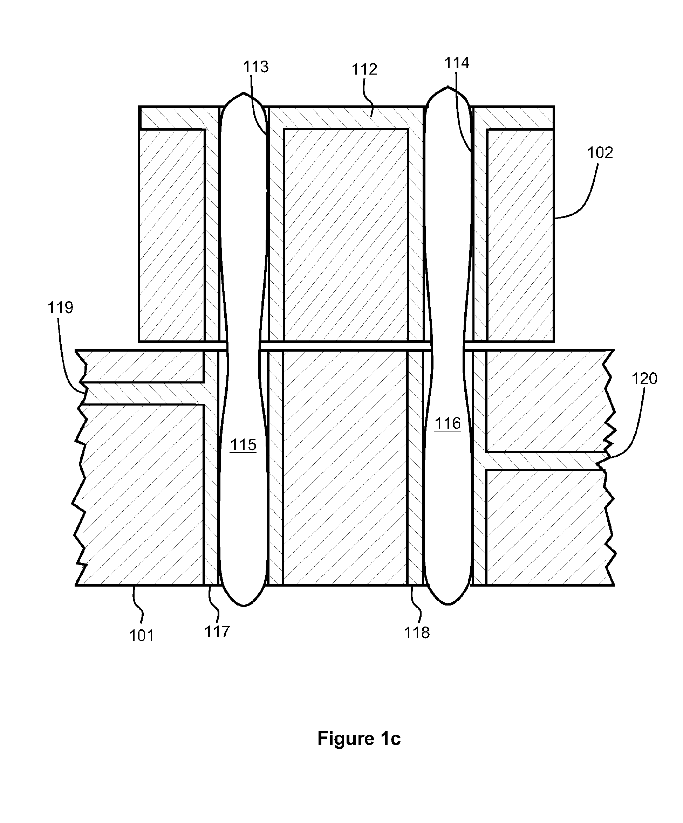

Figure 1a illustrates a circuit board system according to an exemplifying embodiment of the invention. Figure 1b shows a schematic view of a section taken along the line A-A shown in figure 1a. Figure 1c shows a schematic view of a detail 140 of the section view shown in figure 1b. The circuit board system comprises a first circuit board 101 furnished with electrical components attached by soldering and/or by other suitable methods to the circuit board. Some of the electrical components are denoted with reference numbers 103, 104, 105, 106, 107, 108, 109, 110, and 111. In the exemplifying case illustrated in figures 1a and 1b, the circuit board system comprises electrical connector elements 123 and 124. The circuit board system can be, for example, a plug-in unit which is installed by pushing it in the positive x-direction of a coordinate system 190 into a device for receiving the plug-in unit. The circuit board 101 comprises a body made of one or more layers of electrically insulating material and electrical conductors on one or both of the surfaces of the circuit board and/or between the layers of the electrically insulating material. Each of the electrical components can be an integrated circuit such as a processor or a memory, or a discrete component such as a resistor, a capacitor, an inductor, a transistor, or a diode. In the exemplifying case illustrated in figures 1a and 1b, the electrical components 103, 104, 105, 108, and 109 are integrated circuits and the electrical components 106, 107, 110, and 111 are discrete components.

The electrical components constitute together with the electrical conductors of the circuit board a first functional entity 121 and a second functional entity 122. The first functional entity 121 can be, for example but not necessarily, a DC-to-DC or AC-to-DC power supply converter of the circuit board system and the second functional entity 122 can be, for example but not necessarily, a signal processing part of the circuit board system. For another example, the first functional entity 121 can be an analogue signal processing part of the circuit board system and the second functional entity 122 can be a digital signal processing part of the circuit board system. For still one example, the first functional entity 121 can be an equalizer of a digital signal processing part of the circuit board system and the second functional entity 122 can be a detector of the digital signal processing part. The circuit board system can be, for example but not necessarily, a part of a telecommunication device, and the second functional entity 122 may comprise a processing system for supporting one or more data transfer protocols such as, for example, Internet Protocol "IP", Ethernet protocol, MultiProtocol Label Switching "MPLS" protocol, and Asynchronous Transfer Mode "ATM".

The circuit board system comprises electrically conductive elements providing at least one galvanic connection between the first and second functional entities 121 and 122. The electrically conductive elements are illustrated in figure 1c which shows a magnified view of the detail 140 of figure 1b. The electrically conductive elements comprise a first electrically conductive lining 117 in a first hole of the circuit board 101 and a second conductive lining 118 in a second hole of the circuit board 101. The electrically conductive elements comprise first and second press-fit "PF" pins 115 and 116 which provide friction fits with the first and second conductive linings 117 and 118, respectively. The electrically conductive elements comprise a connection part 102 that forms a galvanic connection between the first and second press-fit connection pins 115 and 116. In the exemplifying case illustrated in figures 1a-1c, the connection part 102 is a second circuit board that comprises an electrical conductor 112 comprising third and fourth electrically conductive linings 113 and 114 in holes of the second circuit board as illustrated in figure 1c. The press-fits pins 115 and 116 are arranged to provide friction fits with the third and fourth electrically conductive linings 113 and 114. Therefore, a galvanic connection is formed between electrical conductors 119 and 120 of the circuit board 101. The electrical conductor 119 can be a part of, for example, the first functional entity 121 and the electrical conductor 120 can be a part of the second functional entity 122. Thus, the galvanic connection is formed between the first and second functional entities. In the above-described exemplifying case, there are friction fits between the connection part 102 and the press-fits pins 115 and 116. It is also possible that the press-fits pins 115 and 116 are soldered to the connection part 102. Furthermore, it is possible that the connection part 102 is not a circuit board but a piece of metal which comprises holes for the press-fit pins. Furthermore, it is possible to use, instead of the press-fit pins 115 and 116 and the connection part 102, a stapler pin -shaped piece of metal wire whose ends constitute press-fit pins capable of providing the friction fits with the electrically conductive linings 117 and 118 of the holes of the circuit board 101.

In the exemplifying case illustrated in figures 1a-1c, the connection part 102 comprises elongated portions attached to areas of the surface of the circuit board 101 which are free from the electrical components in order to provide barriers capable of providing mechanical protection for the electrical components 103-111. Therefore, the connection part 102 constitutes also a protection element for protecting the electrical components. The body of the connection part 102 is preferably made of the same material as the electrically insulating body of the circuit board 101 so as to make the thermal expansion coefficient of the connection part 102 to be substantially the same as that of the circuit board 101. The connection part 102 does not increase the thickness of the circuit board system in the direction perpendicular to the circuit board 101 if the thickness of the connection part is at most the maximum of the heights of all components on the surface of the circuit board, where the heights are measured from the surface of the circuit board. Also in this case, the connection part is capable of protecting the components against mechanical impacts in directions parallel to the circuit board and in directions having a slight angle with respect to the surface of the circuit board 101. The thickness of the connection part 102 is advantageously, but not necessarily, greater than the maximum of the heights of the electrical components to be protected and lower than the maximum of the heights of all components on the surface of the circuit board. If the thickness of the connection part is greater than the maximum of the heights of the electrical components to be protected, the connection part is capable of protecting these electrical components in a situation in which the circuit board is being pressed against a wide flat surface. In addition to the attachment provided by the press-fit connection pins, the connection part 102 can be attached to the circuit board 101, for example, using glue, screws, and/or plugs shaped so that they provide form locking with edges of respective holes of the circuit board.

The electrical components, the conductors of the circuit board 101, and the electrical connections between the electrical components and the conductors of the circuit board are arranged in a way that the first and second functional entities 121 and 122 are disconnected from each other so that operations of the first and second functional entities are free from mutual interactions when the connection part 102 has not been installed to the circuit board 101. The above-described arrangement, where the connection part 102 connects the functional entities 121 and 122 to each other, allows the functional entities to be tested and/or otherwise electrically activated separately prior to installing the connection part, and subsequent installation of the connection part makes the circuit board system ready for e.g. functional testing where the functional entities 121 and 122 are co-operating with each other.

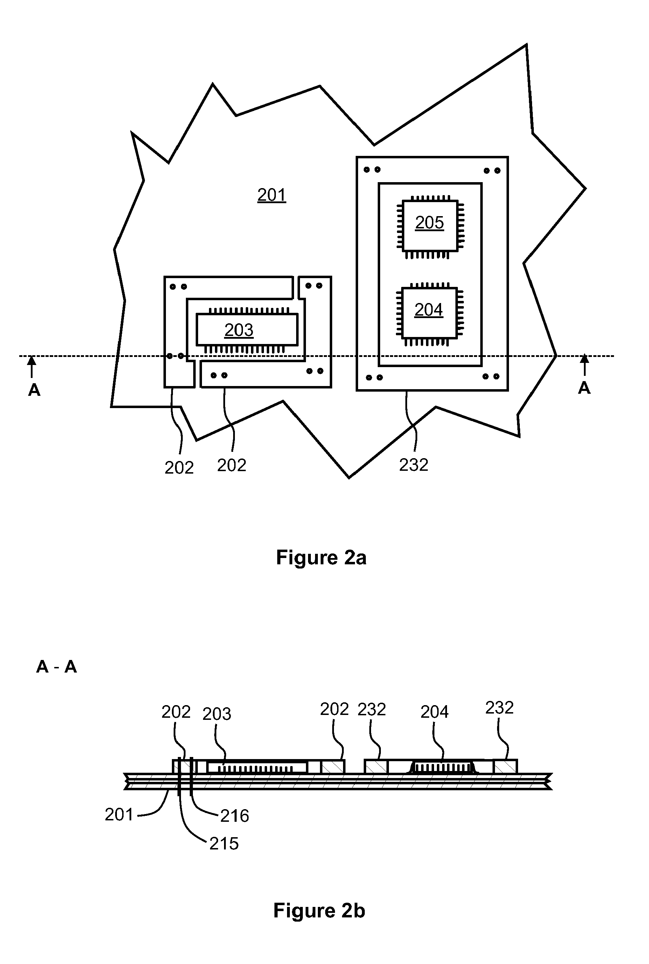

Figure 2a illustrates a part of a circuit board system according to an exemplifying embodiment of the invention, and figure 2b shows a schematic view of a section taken along the line A-A shown in figure 2a. The circuit board system comprises more than one connection part on a surface of a circuit board 201. Each of the connection parts has a loop-shaped structure surrounding, and therefore also protecting, at least one of the electrical components. In the exemplifying case illustrated in figures 2a and 2b, a connection part 202 surrounds an electrical component 203 and a connection part 232 surrounds electrical components 204 and 205. As illustrated in figure 2a, the connection part 202 consists of two pieces which together form the loop-shaped structure surrounding the electrical component 203. The connection part 202 is configured to provide, together with press-fit connection pins 215 and 106, a galvanic connection between functional entities of the circuit board system. It is to be noted that the circuit board system may comprise, in addition to the connection parts providing one or more galvanic connections, mere protection elements the only purpose of which is to protect the electrical components.

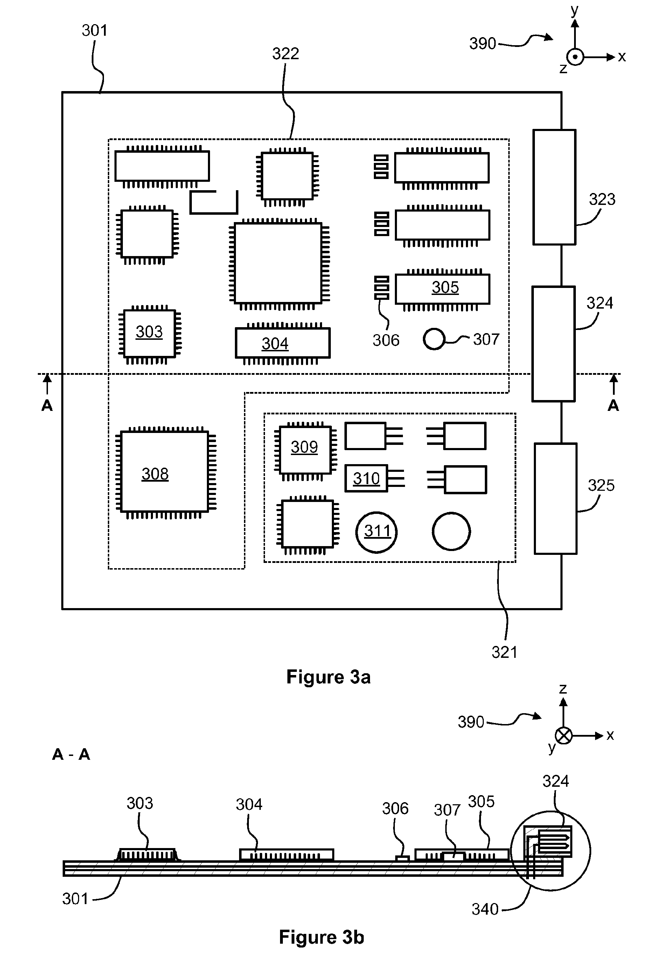

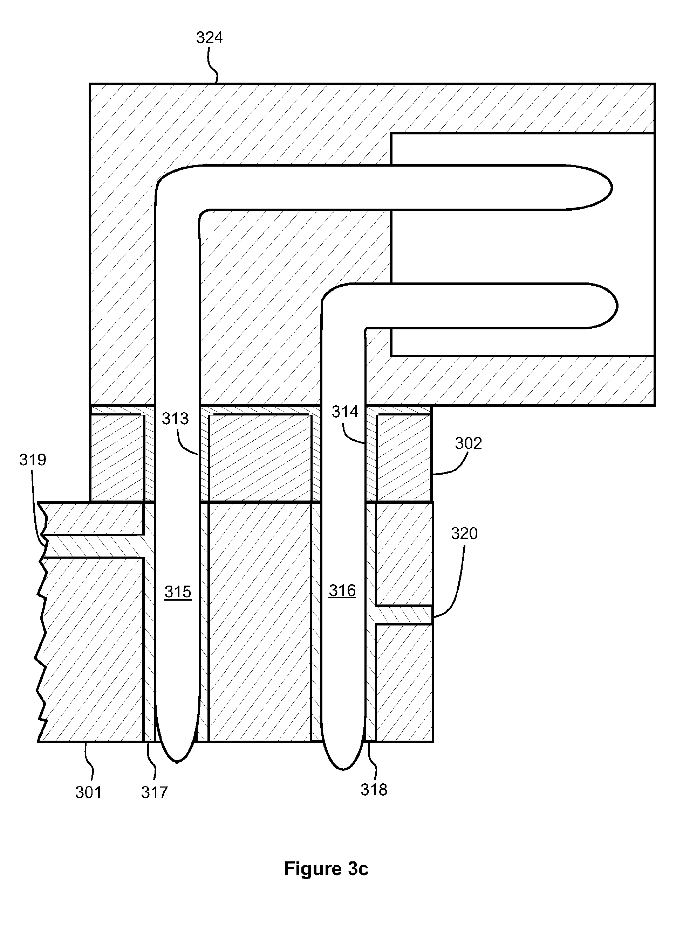

Figure 3a illustrates a circuit board system according to an exemplifying embodiment of the invention. Figure 3b shows a schematic view of a section taken along the line A-A shown in figure 3a. Figure 3c shows a schematic view of a detail 340 of the section view shown in figure 3b. The circuit board system comprises a first circuit board 301 furnished with electrical components attached by e.g. soldering. Some of the electrical components are denoted with reference numbers 303, 304, 305, 306, 307, 308, 309, 310, and 311. In the exemplifying case illustrated in figures 3a and 3b, the circuit board system comprises electrical connector elements 323, 324 and 325. The circuit board system can be, for example, a plug-in unit which is installed by pushing it in the positive x-direction of a coordinate system 390 into a device for receiving the plug-in unit.

The electrical components constitute together with the electrical conductors of the circuit board 301a first functional entity 321 and a second functional entity 322. The circuit board system comprises electrically conductive elements providing at least one galvanic connection between the first and second functional entities 321 and 322. The electrically conductive elements are illustrated in figure 3c which shows a magnified view of the detail 340 of figure 3b. The electrically conductive elements comprise a first electrically conductive lining 317 in a first hole of the circuit board 301 and a second conductive lining 318 in a second hole of the circuit board. The electrically conductive elements comprise first and second press-fit "PF" pins 315 and 316 which provide friction fits with the first and second conductive linings 317 and 318, respectively. The first and second press-fit connection pins 315 and 316 are such press-fit connection pins of a press-fit installable electrical component 324 which press-fit connection pins can be short-circuited without causing harm to the operation of the press-fit installable electrical component. In the exemplifying case illustrated in figures 3a-3c, the press-fit installable electrical component 324 is an electrical connector element on an edge of the circuit board 301. The press-fit connection pins 315 and 316 are related to un-used electrical poles of the connector element. The electrically conductive elements further comprise a connection part 302 that comprises third and fourth electrically conductive linings 313 and 314 in holes of the connector part 302 as illustrated in figure 3c. The electrically conductive linings 313 and 314 are dimensioned to provide friction fits with the press-fit connection pins 315 and 316, and thus the connection part 302 forms a galvanic connection between the press-fit connection pins 315 and 316. As illustrated in figure 3c, the connection part 302 is located between the circuit board 301 and the press-fit installable electrical component 324, and the connection part 302 does not consume the surface area of the circuit board 301. The connection part 302 can be, for example, a second circuit board as illustrated in figure 3c or a piece of metal having holes dimensioned to provide the desired friction fits with the press-fit connection pins 315 and 316. As can be seen from figure 3c, a galvanic connection is formed between electrical conductors 319 and 320 of the circuit board 301. The electrical conductor 319 can be a part of, for example, the first functional entity 321 and the electrical conductor 320 can be a part of the second functional entity 322. Thus, the galvanic connection is formed between the first and second functional entities.

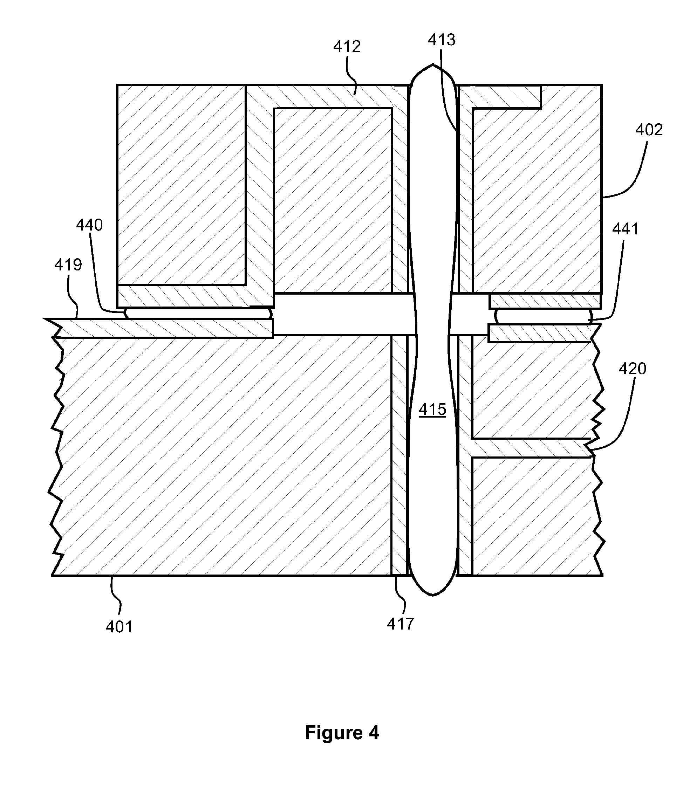

Figure 4 shows a schematic view of a section taken from a detail of a circuit board system according to an exemplifying embodiment of the invention. The circuit board system comprises a first circuit board 401 furnished with electrical components attached by e.g. soldering. The electrical components are not shown in figure 4. The circuit board system comprises a second circuit board 402 that is attached to the first circuit board 401 with solder joints 440 and 441. The circuit board 401 comprises a hole having an electrically conductive lining 417 connected to an electrical conductor 420. The circuit board 402 comprises a hole having an electrically conductive lining 413 connected via an electrical conductor 412 and the solder joint 440 to an electrical conductor 419 of the circuit board 401. The circuit board system comprises a press-fit connection pin 415 providing friction fits with the electrically conductive linings 413 and 417. Therefore, there is a galvanic connection between the electrical conductors 419 and 420 of the circuit board 401. The electrical conductor 419 can be a part of a first functional entity of the circuit board system and the electrical conductor 420 can be a part of a second functional entity of the circuit board system. Thus, the galvanic connection is formed between the first and second functional entities. In the exemplifying case illustrated in figure 4, each galvanic connection between the functional entities can be provided with a single press-fit connection pin. The circuit board 402 can be attached to the circuit board 401, for example, in the same soldering process in which surface mounted device -type "SMD" electrical components are soldered to the circuit board 401. An inconveniency related to this embodiment of the invention is the need for sufficiently accurate alignment between the holes of the circuit boards 401 and 402.

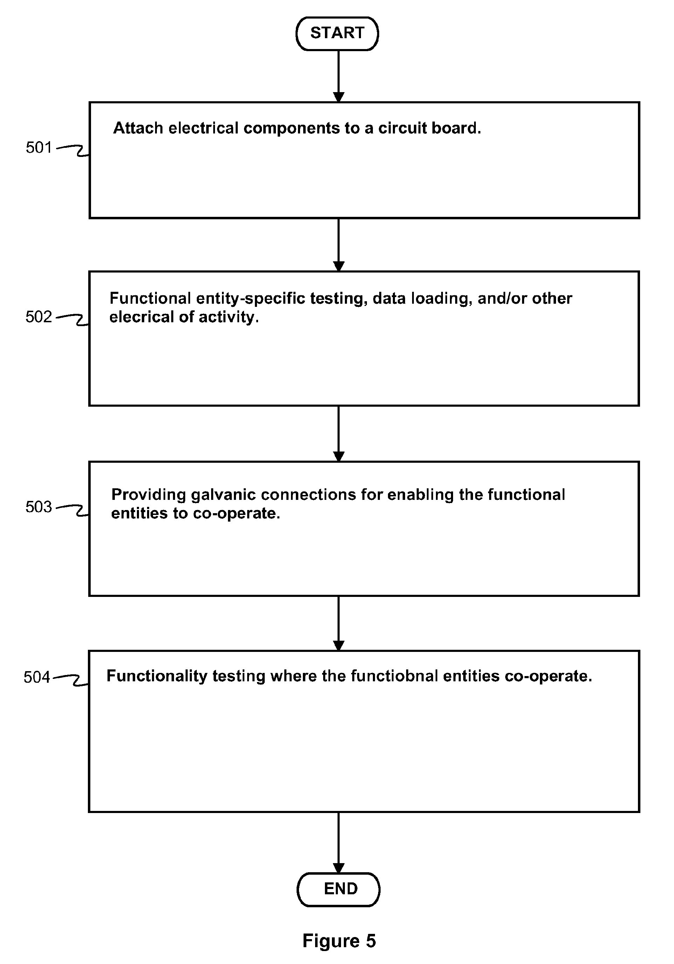

Figure 5 shows a flowchart of a method according to an exemplifying embodiment of the invention for manufacturing a circuit board system. The method comprises the following actions:
- action 501: attaching, e.g. by soldering, electrical components to a first circuit board, the electrical components constituting together with electrical conductors of the first circuit board a first functional entity and a second functional entity,
- action 502: directing electrical activity, e.g. testing and/or loading data, to at least one of the first and second functional entities, the first and second functional entities being disconnected from each other so that operations of the first and second functional entities are free from mutual interactions, and
- action 503: providing at least one galvanic connection between the first and second functional entities with the aid of electrically conductive elements comprising a first electrically conductive lining in a hole of the first circuit board and a first press-fit connection pin providing a friction fit with the first electrically conductive lining, the at least one galvanic connection enabling the first and second functional entities to co-operate.

In a method according to an exemplifying embodiment of the invention, the electrically conductive elements further comprise a second electrically conductive lining in another hole of the first circuit board, a second press-fit connection pin providing a friction fit with the second electrically conductive lining, and a connection part providing a galvanic connection between the first and second press-fit connection pins.

In a method according to an exemplifying embodiment of the invention, the first and second press-fit connection pins are press-fit connection pins of a press-fit installable electrical component, and the connection part comprises holes for providing friction fits with the first and second press-fit connection pins, and the method comprises placing the connection part between the first circuit board and the press-fit installable electrical component when installing the press-fit installable electrical component so as to provide the at least one galvanic connection.

In a method according to an exemplifying embodiment of the invention, the press-fit installable electrical component is an electrical connector element on an edge of the first circuit board.

In a method according to an exemplifying embodiment of the invention, the electrical activity directed to at least one of the first and second functional entities comprises at least one of the following: testing the at least one of the first and second functional entities, loading data to a memory of the at least one of the first and second functional entities.

A method according to an exemplifying embodiment of the invention further comprises testing functionality of the circuit board system so that the first and second functional entities are co-operating with each other via the at least one galvanic connection during the testing of the functionality, action 504 shown in figure 5.

The specific examples provided in the description given above should not be construed as limiting the applicability and/or the interpretation of the appended claims.

## Claims

1. A circuit board system comprising:
- a first circuit board (101, 201, 301, 401) furnished with electrical components attached to the first circuit board, the electrical components (103-111, 203-205, 303-311) constituting together with electrical conductors of the first circuit board two or more functional entities including a first functional entity (121, 321) and a second functional entity (122, 322), and
- electrically conductive elements providing at least one galvanic connection between the first and second functional entities, the at least one galvanic connection enabling the first and second functional entities to co-operate with each other, and without the at least one galvanic connection the first and second functional entities being disconnected from each other so that operations of the first and second functional entities are substantially free from mutual interactions,
wherein the electrically conductive elements comprise:
- a first electrically conductive lining (117, 317, 417) in a hole of the first circuit board,
- a first press-fit connection pin (115, 215, 315, 415) providing a friction fit with the first electrically conductive lining,
- a second electrically conductive lining (118, 318) in another hole of the first circuit board,
- a second press-fit connection pin (116, 316) providing a friction fit with the second electrically conductive lining, and
- a connection part (102, 302) providing a galvanic connection between the first and second press-fit connection pins,
**characterized in that** the first and second press-fit connection pins are press-fit connection pins of a press-fit installable electrical connector element (324) on an edge of the first circuit board, and the connection part (302) providing the galvanic connection between the first and second press-fit connection pins is located between the first circuit board (301) and the press-fit installable electrical connector element.

2. A circuit board system according to claim 1, wherein the connection part is a piece of metal.

3. A circuit board system according to claim 2, wherein the first and second press-fit connection pins are configured to provide friction fits with walls of holes of the piece of metal.

4. A circuit boards system according to claim 1, wherein the connection part is a second circuit board comprising an electrical conductor (112) providing the galvanic connection between the first and second press-fit connection pins.

5. A circuit board system according to claim 4, wherein the electrical conductor of the second circuit board comprises a third electrically conductive lining (113, 313) in a hole of the second circuit board and a fourth electrically conductive lining (114, 314) in another hole of the second circuit board, the first press-fit connection pin (115, 315) providing friction fits with the first and third electrically conductive linings and the second press-fit connection pin (116, 316) providing friction fits with the second and fourth electrically conductive linings.

6. A circuit board system according to any of claims 1-5, wherein the first functional entity (121, 321) is a power supply converter of the circuit board system and the second functional entity (122, 322) is a signal processing part of the circuit board system.

7. A circuit board system according to claim 6, wherein the signal processing part comprises a processing system for supporting at least one of the following data transfer protocols: Internet Protocol "IP", Ethernet protocol, MultiProtocol Label Switching "MPLS" protocol, Asynchronous Transfer Mode "ATM".

8. A method for manufacturing a circuit board system, the method comprising:
- attaching (501) electrical components to a first circuit board, the electrical components constituting together with electrical conductors of the first circuit board two or more functional entities including a first functional entity and a second functional entity,
- directing (502) electrical activity to at least one of the first and second functional entities, the first and second functional entities being disconnected from each other so that operations of the first and second functional entities are substantially free from mutual interactions, and
- providing (503), after the directing of the electrical activity, at least one galvanic connection between the first and second functional entities with the aid of electrically conductive elements, the at least one galvanic connection enabling the first and second functional entities to co-operate with each other,
wherein the electrically conductive elements comprise:
- a first electrically conductive lining in a hole of the first circuit board,
- a first press-fit connection pin providing a friction fit with the first electrically conductive lining,
- a second electrically conductive lining in another hole of the first circuit board,
- a second press-fit connection pin providing a friction fit with the second electrically conductive lining, and
- a connection part providing a galvanic connection between the first and second press-fit connection pins,
**characterized in that** the first and second press-fit connection pins are press-fit connection pins of a press-fit installable electrical connector element (324) on an edge of the first circuit board, and the connection part (302) providing the galvanic connection between the first and second press-fit connection pins is placed to locate between the first circuit board and the press-fit installable electrical connector element.

9. A method according to claim 8, wherein the directing (502) of the electrical activity to at least one of the first and second functional entities comprises at least one of the following: testing the at least one of the first and second functional entities, loading data to a memory of the at least one of the first and second functional entities.

10. A method according to claim 8 or 9, wherein the method further comprises testing (504) functionality of the circuit board system so that the first and second functional entities are co-operating with each other via the at least one galvanic connection during the testing of the functionality.
